# EUROPEAN PATENT APPLICATION

(11) **EP 4 575 032 A1**
(43) Date of publication of application: **25.06.2025**
(21) Application number: 23219125.4
(22) Date of filing: 21.12.2023
(51) Int. Cl.: C23C 16/02, C23C 16/04, C23C 16/455, C23C 16/48, C30B 25/00, H01L 21/02

(54) **METHOD OF FORMING A PATTERNED LAYER OF MATERIAL, METHOD OF FORMING AN ELECTRONIC DEVICE, APPARATUS FOR FORMING A PATTERNED LAYER OF MATERIAL**

(71) Applicant: ASML Netherlands B.V., 5500 AH Veldhoven (NL)
(72) Inventor: VENUGOPALAN, Syam Parayil, 5500 AH Veldhoven (NL); FARAMARZI, Vina, 5500 AH Veldhoven (NL); GAURY, Benoit Herve, 5500 AH Veldhoven (NL)
(74) Representative: ASML Netherlands B.V.

(57) **Abstract**

The disclosure relates to methods and apparatus for forming a patterned layer of material. In one arrangement, the method comprises providing a substrate having a deposited layer of diamondoids on at least a portion of the substrate. A selected portion of a surface of the substrate is irradiated during a déposition process, the irradiation being such as to locally drive the déposition process in the selected portion and thereby form a patterned layer of material in a pattern defined by the selected portion.

## Description

### FIELD

The present disclosure relates to methods and apparatus for forming a patterned layer of material. The methods and apparatus are particularly applicable to providing patterns of two-dimensional materials, for example for manufacturing FET devices.

### BACKGROUND

As semiconductor manufacturing processes continue to advance, the dimensions of circuit elements have continually been reduced while the amount of functional elements, such as transistors, per device has been steadily increasing, following a trend commonly referred to as 'Moore's law'. To keep up with Moore's law the semiconductor industry is seeking technologies that enable creation of increasingly smaller features.

For some types of electronic device, scaling down of the device features can cause performance challenges, such as the short-channel effect that occurs in MOSFETs when the channel length becomes comparable to the depletion layer widths of the source and drain junctions. These challenges can sometimes be addressed using two-dimensional materials, which are atomically thin and can have relatively low dielectric constants. Two-dimensional materials can have properties desirable for use in other contexts also. Two-dimensional materials may be used to replace gate oxide where a high dielectric constant is required. Two-dimensional materials may be used to replace interconnects where high conductivity is preferred.

Various deposition technologies exist for fabricating two-dimensional materials. Such deposition technologies include chemical vapor deposition (CVD), mechanical cleaving (exfoliation), molecular beam epitaxy (MBE), atomic layer deposition (ALD), liquid-phase exfoliation, and others. A challenge with many of these deposition technologies has been the high temperatures that are required for the processes to work efficiently (with high speed and quality). High temperatures can degrade or damage previously deposited layers and/or restrict the range of previously deposited layers that can be used. The previously deposited layers must be formed so that they can withstand the high temperatures to an acceptable degree, for example by having melting points above the temperatures reached during the deposition process.

In approaches based on exfoliation, the two-dimensional material can be grown offline without restrictions on temperature, but it is difficult to perform the exfoliation and transfer process with high throughput and low defectivity.

Patterning two-dimensional materials presents further challenges due to their fragile nature. Two-dimensional materials can be damaged or delaminated very easily. Two-dimensional materials can be damaged, for example, by traditional patterning processes such as resist coating, lithography, etch and resist stripping. Typical photoresists for DUV and EUV lithography may also be incompatible with two-dimensional materials, for example by being hydrophilic while the two-dimensional materials are hydrophobic. Even where great care is taken during processing, this physical incompatibility will result in unwanted sticking of resist residues on structures and a reduction in a quality of contact between the structures and other layers.

Laser etching has been proposed for patterning two-dimensional materials. Laser etching uses a laser to locally heat the surface to gradually melt material and remove the material by evaporation. Laser processing techniques rely on scanning from point to point, which lowers yield relative to some alternative approaches.

It is possible to induce deposition of material in a selected pattern using EUV radiation. However, it has proven difficult to achieve high throughput due to the need for very high EUV doses.

### SUMMARY

It is an object of the invention to provide alternative or improved methods and apparatus for forming a patterned layer of material on a substrate. It is a particular object to improve throughput and/or quality.

According to an aspect, there is provided a method of forming a patterned layer of material on a substrate, comprising: providing a substrate having a deposited layer of diamondoids on at least a portion of the substrate; and irradiating a selected portion of a surface of the substrate during a deposition process, the irradiation being such as to locally drive the deposition process in the selected portion and thereby form a patterned layer of material in a pattern defined by the selected portion.

The irradiation generates secondary electrons and the layer of diamondoids increases a proportion of the secondary electrons that contribute to driving the deposition process by reducing the work function where the deposited layer of diamondoid is present. Increasing the proportion of secondary electrons that contribute to driving the deposition process improves a rate of deposition per unit area, thereby improving throughput.

In an embodiment, the diamondoids in the deposited layer are selected and/or functionalized to have a relative dielectric constant higher than about 2.0, optionally equal to or higher than about 3.0. The layer of diamondoids may thus provide a layer of relative high-κ: material that can be retained as part of an electronic device being manufactured. High-κ may be desirable to implement a gate dielectric, where it may contribute for example to improved electrostatic control of a channel and/or faster transistor switching.

In an embodiment, the diamondoids in the deposited layer are selected and/or functionalized to have a relative dielectric constant below about 3.0. The layer of diamondoids may thus provide a layer of low-x material that can be retained as part of an electronic device being manufactured, such as to contribute to electrical isolation between conducting parts of a device (e.g., between wire interconnects or between components of transistors such as between the gate and substrate of a field-effect transistor such as a MOSFET) and thereby or otherwise, enable faster switching speeds.

In an embodiment, the method further comprises applying a bias voltage of alternating polarity to the substrate during the deposition. The bias voltage further increases a proportion of the secondary electrons that contribute to driving the deposition process. Configuring the bias voltage to have alternating polarity avoids excessive charge build up on the substrate. The bias voltage thus further improves throughput. The bias voltage can also further improve spatial definition of the radiation induced deposition, thereby further improving the quality of the pattern formed on the substrate.

In an embodiment, the bias voltage has a non-sinusoidal bias voltage waveform. Providing a non-sinusoidal bias voltage makes it possible to reduce variations in the electric field in an internal volume of the substrate adjacent to the surface, thereby reducing a range of energies of secondary electrons driven to the surface. Reducing the range of energies of secondary electrons means that a greater proportion of the secondary electrons can contribute optimally to driving the deposition process, thereby improving throughput.

In an embodiment, the bias voltage waveform is periodic and each period comprises: a negative bias portion during which secondary electrons in the substrate are driven towards the surface in the selected portion; and a positive bias portion during which secondary electrons in the substrate are driven away from the surface in the selected portion. In such an arrangement, the voltage of the bias voltage waveform may furthermore be arranged to vary during at least a majority of the negative bias portion in such a manner as to at least partially compensate for charging of the substrate caused by impingement of ions onto the substrate from a plasma during the negative bias portion. Compensating for the charging of the substrate in this manner contributes to reducing the range of energies of secondary electrons impinging on the target layer by reducing variations in the electric field in an internal volume of the substrate adjacent to the surface in the selected portion.

In an embodiment, the variation of the voltage of the bias voltage waveform during the negative bias portion is such as to maintain a substantially time invariant electric field in an internal volume of the substrate adjacent to the surface of the substrate in the selected portion during the negative bias portion. Maintaining a substantially time invariant electric field in the internal volume adjacent to the surface promotes a high level of control of energies of secondary electrons reaching the surface, thereby promoting high throughput.

In an embodiment, the irradiation of the selected portion is performed with electromagnetic radiation having a wavelength less than 100nm. This allows the secondary electrons to be generated efficiently and promotes high spatial resolution.

According to an aspect, there is provided a method of forming an electronic device, comprising forming a patterned layer of material on a substrate using any of the methods of forming a patterned layer of material on a substrate disclosed herein, wherein the electronic device comprises a retained portion of the deposited layer of diamondoids, the retained portion configured to contribute to electronic functionality of the electronic device.

According to an aspect, there is provided an apparatus for forming a patterned layer of material on a substrate, comprising: a substrate having a deposited layer of diamondoids on at least a portion of the substrate; a projection system configured to irradiate a selected portion of a surface of the substrate during a deposition process; and an environment control system configured to contain the substrate in a controlled gaseous environment during the irradiation of selected portion, the controlled gaseous environment being such as to support the deposition process.

### BRIEF DESCRIPTION OF THE DRAWINGS

Embodiments of the disclosure will now be described, by way of example only, with reference to the accompanying schematic drawings, in which:
Figure 1 depicts a first example of a lithographic system comprising a lithographic apparatus and a radiation source;
Figure 2 depicts a second example of a lithographic system comprising a lithographic apparatus and a radiation source;
Figure 3 schematically depicts irradiation of a selected portion of a substrate to locally drive a deposition process;
Figure 4 schematically depicts formation of a patterned layer of material defined by the selected portion;
Figure 5 is a graph showing the results of simulated secondary electron yield (SE) as a function of landing energy of primary electrons on a diamondoid material.
Figure 6 is a schematic side sectional view of a portion of a substrate having a deposited layer of diamondoids on at least a portion of the substrate during irradiation of a selected portion of a surface of the substrate;
Figure 7 depicts the arrangement of Figure 6 after the deposition process has formed a patterned layer of material;
Figure 8 depicts the arrangement of Figure 7 after an optional subsequent etching process has removed a portion of the deposited layer of diamondoids;
Figure 9 is a schematic side sectional view of a portion of a substrate having a patterned deposited layer of diamondoids on at least a portion of the substrate during irradiation of a selected portion of a surface of the substrate;
Figure 10 depicts the arrangement of Figure 9 after the deposition process has formed a patterned layer of material;
Figure 11 depicts an apparatus for forming a patterned layer of material;
Figure 12 schematically depicts average trajectories of secondary electrons from a focus region towards a surface of a substrate in the absence of a bias voltage applied to the substrate;
Figure 13 schematically depicts average trajectories of secondary electrons in the arrangement of Figure 12 with a bias voltage applied to the substrate;
Figure 14 schematically depicts variation of substrate voltage against time in a transient phase shortly after an initial turning on of a bias voltage;
Figure 15 schematically depicts variation of substrate voltage against time in a steady state;
Figure 16 is a graph showing a distribution of energies of secondary electrons, plotted as the number of electrons at energy E, N(E), against E, for two different bias voltage waveforms;
Figure 17 is a graph showing a distribution of energies of secondary electrons where no bias voltage is applied, with superimposed rectangles showing approximate ranges of energies for which three different types of bond dissociations are favoured;
Figure 18 depicts an example non-sinusoidal bias voltage waveform;
Figure 19 is a graph showing three example non-sinusoidal bias voltage waveforms having different amplitudes; and
Figure 20 is a graph showing distributions of energies of secondary electrons for the three bias voltage waveforms shown in Figure 19.

### DETAILED DESCRIPTION

A lithographic apparatus is a machine constructed to apply a desired pattern onto a substrate. A lithographic apparatus can be used, for example, in the manufacture of integrated circuits (ICs). A lithographic apparatus may, for example, project a pattern at a patterning device (e.g., a mask) onto a layer of radiation-sensitive material (resist) provided on a substrate.

To project a pattern on a substrate a lithographic apparatus may use electromagnetic radiation. The wavelength of this radiation determines the minimum size of features which are patterned on the substrate. Typical wavelengths currently in use are 365 nm (i-line), 248 nm, 193 nm and 13.5 nm. A lithographic apparatus which uses extreme ultraviolet (EUV) radiation, having a wavelength of less than 100nm, optionally in the range of 5-100 nm, optionally within a range of 4 nm to 20 nm, for example 6.7 nm or 13.5 nm, may be used to form smaller features on a substrate than a lithographic apparatus which uses, for example, radiation with a wavelength of 193 nm.

In the present document, the terms "radiation" and "beam" are used to encompass all types of electromagnetic radiation unless stated otherwise, including ultraviolet radiation (e.g. with a wavelength of 365, 248, 193, 157 or 126 nm) and EUV (extreme ultra-violet radiation, e.g. having a wavelength in the range of about 5-100 nm), as well as electron beam radiation.

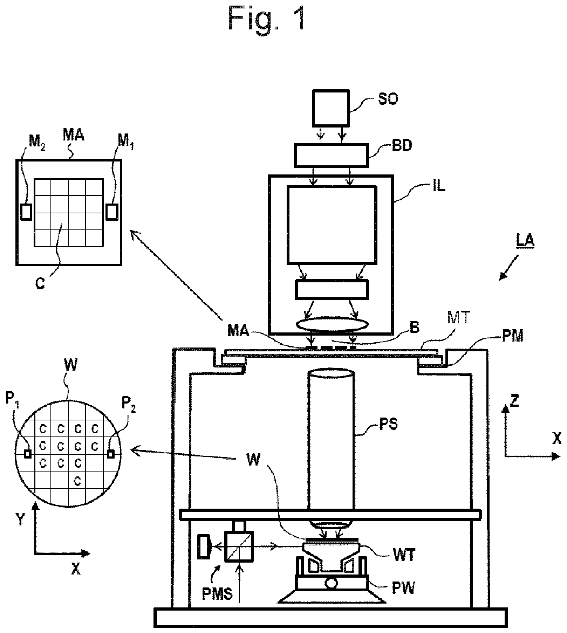

Figure 1 schematically depicts a lithographic apparatus LA. The lithographic apparatus LA includes an illumination system (also referred to as illuminator) IL configured to condition a radiation beam B (e.g., UV radiation, DUV radiation or EUV radiation), a mask support (e.g., a mask table) MT constructed to support a patterning device (e.g., a mask) MA and connected to a first positioner PM configured to accurately position the patterning device MA in accordance with certain parameters, a substrate support (e.g., a wafer table) WT constructed to hold a substrate (e.g., a resist coated wafer) W and connected to a second positioner PW configured to accurately position the substrate support in accordance with certain parameters, and a projection system (e.g., a refractive projection lens system) PS configured to project a pattern imparted to the radiation beam B by patterning device MA onto a target portion C (e.g., comprising one or more dies) of the substrate W.

In operation, the illumination system IL receives a radiation beam from a radiation source SO, e.g. via a beam delivery system BD. The illumination system IL may include various types of optical components, such as refractive, reflective, magnetic, electromagnetic, electrostatic, and/or other types of optical components, or any combination thereof, for directing, shaping, and/or controlling radiation. The illuminator IL may be used to condition the radiation beam B to have a desired spatial and angular intensity distribution in its cross section at a plane of the patterning device MA.

The term "projection system" PS used herein should be broadly interpreted as encompassing various types of projection system, including refractive, reflective, catadioptric, anamorphic, magnetic, electromagnetic and/or electrostatic optical systems, or any combination thereof, as appropriate for the exposure radiation being used, and/or for other factors such as the use of an immersion liquid or the use of a vacuum. Any use of the term "projection lens" herein may be considered as synonymous with the more general term "projection system" PS.

The lithographic apparatus LA may be of a type wherein at least a portion of the substrate may be covered by a liquid having a relatively high refractive index, e.g., water, so as to fill a space between the projection system PS and the substrate W - which is also referred to as immersion lithography. More information on immersion techniques is given in US6952253, which is incorporated herein by reference.

The lithographic apparatus LA may also be of a type having two or more substrate supports WT (also named "dual stage"). In such "multiple stage" machine, the substrate supports WT may be used in parallel, and/or steps in preparation of a subsequent exposure of the substrate W may be carried out on the substrate W located on one of the substrate support WT while another substrate W on the other substrate support WT is being used for exposing a pattern on the other substrate W.

In addition to the substrate support WT, the lithographic apparatus LA may comprise a measurement stage. The measurement stage is arranged to hold a sensor and/or a cleaning device. The sensor may be arranged to measure a property of the projection system PS or a property of the radiation beam B. The measurement stage may hold multiple sensors. The cleaning device may be arranged to clean part of the lithographic apparatus, for example a part of the projection system PS or a part of a system that provides the immersion liquid. The measurement stage may move beneath the projection system PS when the substrate support WT is away from the projection system PS.

In operation, the radiation beam B is incident on the patterning device, e.g. mask, MA which is held on the mask support MT, and is patterned by the pattern (design layout) present on patterning device MA. Having traversed the mask MA, the radiation beam B passes through the projection system PS, which focuses the beam onto a target portion C of the substrate W. With the aid of the second positioner PW and a position measurement system IF, the substrate support WT can be moved accurately, e.g., so as to position different target portions C in the path of the radiation beam B at a focused and aligned position. Similarly, the first positioner PM and possibly another position sensor (which is not explicitly depicted in Figure 1) may be used to accurately position the patterning device MA with respect to the path of the radiation beam B. Patterning device MA and substrate W may be aligned using mask alignment marks M1, M2 and substrate alignment marks P1, P2. Although the substrate alignment marks P1, P2 as illustrated occupy dedicated target portions, they may be located in spaces between target portions. Substrate alignment marks P1, P2 are known as scribe-lane alignment marks when these are located between the target portions C.

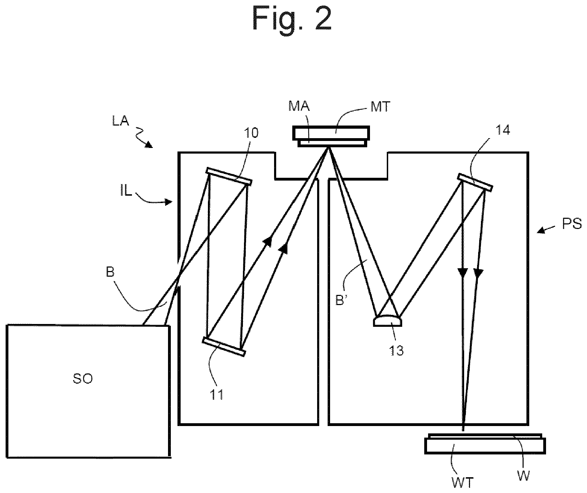

Figure 2 shows a lithographic system comprising a radiation source SO and a lithographic apparatus LA. The radiation source SO is configured to generate an EUV radiation beam B and to supply the EUV radiation beam B to the lithographic apparatus LA. The lithographic apparatus LA comprises an illumination system IL, a support structure MT configured to support a patterning device MA (e.g., a mask), a projection system PS and a substrate table WT configured to support a substrate W.

The illumination system IL is configured to condition the EUV radiation beam B before the EUV radiation beam B is incident upon the patterning device MA. Thereto, the illumination system IL may include a facetted field mirror device 10 and a facetted pupil mirror device 11. The faceted field mirror device 10 and faceted pupil mirror device 11 together provide the EUV radiation beam B with a desired cross-sectional shape and a desired intensity distribution. The illumination system IL may include other mirrors or devices in addition to, or instead of, the faceted field mirror device 10 and faceted pupil mirror device 11.

After being thus conditioned, the EUV radiation beam B interacts with the patterning device MA. As a result of this interaction, a patterned EUV radiation beam B' is generated. The projection system PS is configured to project the patterned EUV radiation beam B' onto the substrate W. For that purpose, the projection system PS may comprise a plurality of mirrors 13,14 which are configured to project the patterned EUV radiation beam B' onto the substrate W held by the substrate table WT. The projection system PS may apply a reduction factor to the patterned EUV radiation beam B', thus forming an image with features that are smaller than corresponding features on the patterning device MA. For example, a reduction factor of 4 or 8 may be applied. Although the projection system PS is illustrated as having only two mirrors 13,14 in Figure 2, the projection system PS may include a different number of mirrors (e.g. six or eight mirrors).

The substrate W may include previously formed patterns. Where this is the case, the lithographic apparatus LA aligns the image, formed by the patterned EUV radiation beam B', with a pattern previously formed on the substrate W.

A relative vacuum, i.e. a small amount of gas (e.g. hydrogen) at a pressure well below atmospheric pressure, may be provided in the radiation source SO, in the illumination system IL, and/or in the projection system PS.

The radiation source SO may be a laser produced plasma (LPP) source, a discharge produced plasma (DPP) source, a free electron laser (FEL) or any other radiation source that is capable of generating EUV radiation.

As mentioned in the introductory part of the description, although there is interest in using two-dimensional materials in semiconductor manufacturing processes, there are challenges in achieving sufficiently high crystalline quality and/or throughput and/or low defectivity. Deposition processes such as CVD and ALD require high temperatures, which can damage underlying layers. For example, typical CVD processes for producing high quality monolayers of two-dimensional crystals can require temperatures higher than 800°C, whereas temperatures above 500°C are typically incompatible with back end of the line CMOS technology. The thermal budget for Si FinFets (fin field-effect transistors), for example, is less than 1050°C for front end of the line (FEOL) and less than 400°C for back end of the line (BEOL). For 2D-FETs (field-effect transistors based on two-dimensional materials) this budget is much lower (typically 450-500°C for both FEOL and BEOL). Exfoliation-based processes avoid these thermal constraints because the deposition of the two-dimensional material can be performed at a separate location, but the transfer process is complex and it is difficult to avoid high defectivity. Traditional patterning processes such as resist coating, lithography, etch and resist stripping are also problematic because they can damage two-dimensional materials. Moreover, conventional lithography techniques represent a challenge for patterning 2D material layers. Due to the nature of these materials, the resulting structures are contaminated and/or damaged with rough edges after a lithography (DUV, EUV, EBL) followed by (dry-, wet-) etch step. Contacts to other layers e.g. source and drain electrodes are not optimal, resulting in a ~ 3.5 times larger Schottky barrier compared to where clean and sharp interfaces are provided.

An alternative approach using EUV-induced deposition can form patterns of two-dimensional material directly, without any resist processing. Examples of such deposition are described in WO2019166318, WO2020207759 and in EP3875633A1, all hereby incorporated in their entirety by reference. It can be difficult, however, with EUV-induced deposition to achieve sufficiently high growth rates of two-dimensional material. The EUV dose (the amount of energy deposited per unit area by the EUV radiation) is constrained in practice by throughput requirements. Typically, increasing the dose lowers throughput. A typical EUV dose limit may be 100 mJ/cm² for example.

Embodiments of the present disclosure provide methods and apparatus for forming a patterned layer 23 of material on a substrate W that address the above challenges. The forming of the patterned layer 23 involves irradiating the substrate W. The irradiation may be performed using any of the arrangements discussed above with reference to Figures 1 and 2. An apparatus for performing the methods may therefore comprise a projection system PS such as that described above with reference to Figures 1 and 2 configured to irradiate the substrate W by projecting a patterned beam of radiation onto the substrate W.

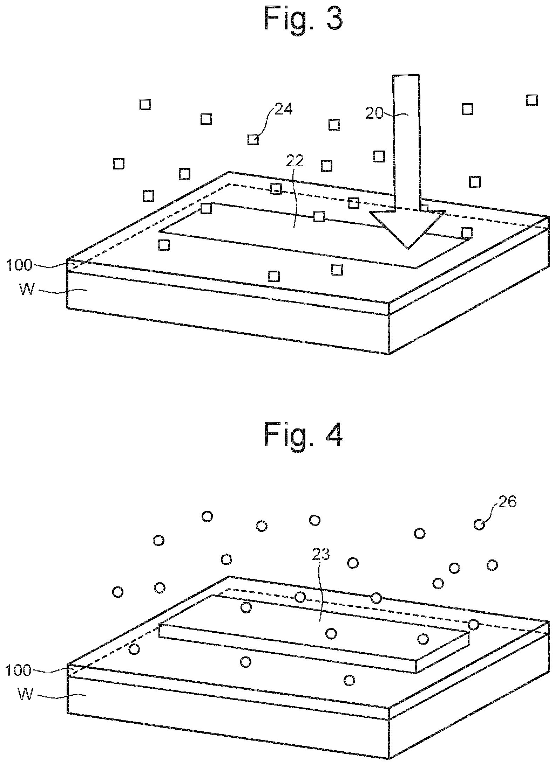

In some embodiments, as exemplified in Figures 3 and 4, the substrate W is irradiated during a deposition process to form the patterned layer 23. The method comprises irradiating 20 a selected portion 22 of a surface of the substrate W during the deposition process. The irradiation may thus apply a dose in the selected portion 22 and not in any other portion on the surface during at least one step of the deposition process. In an embodiment, the patterned layer 23 comprises, consists essentially of, or consists of, a two-dimensional material. A two-dimensional material is a material that shows significant anisotropy of properties in lateral directions within a plane of the material compared to the direction perpendicular to the plane of the material. A class of two-dimensional materials are sometimes referred to as single-layer materials, or monolayers, and may comprise crystalline materials consisting of a single layer of atoms or a small number of single layers of atoms on top of each other. In some embodiments, the two-dimensional material comprises, consists essentially of, or consists of, one or more of the following: one or more 2D allotropes such as graphene and antimonene; one or more inorganic compounds such as MXenes, hexagonal boron nitride (hBN), and a transition metal dichalcogenide (TMD) (a semiconductor of the type MX₂, which may be atomically thin, with the letter M referring to a transition metal atom (e.g. Mo or W) and the letter X referring to a chalcogen atom (e.g. S, Se, or Te)), for example WS₂, MoS₂, WSe₂, MoSe₂, etc. The two-dimensional material may comprise a layer of M atoms sandwiched between two layers of X atoms. The two-dimensional material may comprise any semiconductor two-dimensional material suitable for use as a transistor channel. As mentioned above, the two-dimensional material may compromise a 2D allotrope e.g. graphene or antimonene, or an inorganic compound. The two-dimensional material may comprise a monolayer (or multiple monolayers if the deposition process is repeated). In the embodiment shown, the deposition process is an atomic layer deposition process. In other embodiments, a different deposition process or combination of deposition processes is used, including for example one or more of the following independently or in combination: atomic layer deposition; chemical vapor deposition; plasma-enhanced chemical vapor deposition; epitaxy; sputtering; and electron beam-induced deposition. The formation of the patterned layer 23 may constitute a step in a method of forming at least one layer of a device to be manufactured, such as a semiconductor device (which may be referred to as an electronic device). The two-dimensional material may, for example, form a channel of an FET or a metal cap or an interconnect or a diffusion barrier in an interconnect.

In an embodiment, the irradiation is performed with radiation that is capable of locally driving the deposition process. In an embodiment, the radiation comprises, consists essentially of, or consists of any type of EUV radiation (having a wavelength less than 100nm) that is capable of locally driving the deposition process. The use of EUV radiation provides high spatial resolution. In some other embodiments, the irradiation is performed with radiation comprising, consisting essentially of, or consisting of, higher wavelength radiation, optionally in combination with an immersion liquid, as described below. The higher wavelength radiation may be in the range of 100nm to 400nm (including DUV radiation).

The irradiation locally drives the deposition process in the selected portion 22 to cause the formation of the patterned layer 23, as depicted schematically in Figure 4. The pattern of the patterned layer 23 is defined by the selected portion 22. A pattern is thus formed without needing any resist. No processing to remove a resist is therefore required, which reduces the risk of damage to the patterned layer of material 30 or to any fragile underlying materials. This approach is particularly desirable where resist residue could significantly impact properties of a fragile underlying material and/or where lift-off of resist could significantly damage a fragile underlying material. Examples of fragile underlying materials include very thin film coatings, 2D materials such as graphene or transitional metal dichalcogenides (TMD), and free-standing membranes or thin films. In contrast to traditional lithography-based semiconductor manufacturing processes, instead of being used to break or cross-link molecules in a resist, radiation is being used to drive one or more chemical reactions involved in the deposition process.

Atomic layer deposition is a known thin-film deposition technique in which each of at least two chemicals (which may be referred to as precursor materials) are made to react with the surface of a material in a sequential, self-limiting, manner. In contrast to chemical vapor deposition, the two precursor materials are not normally present simultaneously above the substrate W.

In at least some embodiments using atomic layer deposition, the atomic layer deposition comprises at least a first step and a second step. In the first step, an example of which is depicted in Figure 3, a first precursor material 24 is made to react with a surface of a substrate W. In the second step, an example of which is depicted in Figure 4, a second precursor material 26 is made to react with the substrate W in a region where the first precursor 24 reacted with the substrate W in the first step (in this example the selected portions 22).

As exemplified in Figures 3 and 4, in some embodiments the substrate W has a deposited layer 100 of diamondoids on at least a portion of the substrate W. In the example shown, all of one side of the substrate W is coated with the layer 100 of diamondoids. The layer 100 of diamondoids is thus unpatterned in this example. In other examples, the layer 100 of diamondoids may be provided in a pattern to coat only selected portions of a side of the substrate W.

Diamondoids are cage-like hydrocarbon materials having special characteristics, including low dielectric constants, negative electron affinity, large steric bulk, and electron donating ability. Diamondoids can be classified into: 1) lower diamondoids, including for example adamantane, diamantane, and triamantane; and 2) higher diamondoids, including for example tetramantane and pentamantane, with different isometric structures. The layer 100 comprises, consists essentially of, or consists of diamondoids. Any type of diamondoid may be used. The diamondoids may be functionalized or non-functionalized. Alternatively or additionally, the diamondoids may be surface modified or non-surface modified.

The layer 100 may be arranged so that the irradiated selected portion 22 of the surface of the substrate W is partially or completely covered by the layer 100. The irradiation of the selected portion of the surface of the substrate W may thus be performed through the layer 100 of diamondoids (i.e., such that at least a portion of the photons of the irradiation pass through the layer 100). The layer of diamondoids may therefore be relatively thin. The layer 100 reduces the work function for secondary electrons generated in the substrate W by the irradiation. These secondary electrons may therefore escape via a surface of the layer 100 covering a corresponding surface of the substrate W more easily than via the corresponding surface of the substrate W if the layer 100 were not present. Reducing the work function increases electron emission. The proportion of secondary electrons generated in the substrate W that can contribute to locally driving the deposition process is thereby increased. Increasing the proportion of secondary electrons that can contribute to driving the deposition process increases a rate of deposition per unit area driven by the irradiation, thereby improving throughput for a given dose (or decreases the dose that is required to provide an acceptable throughput).

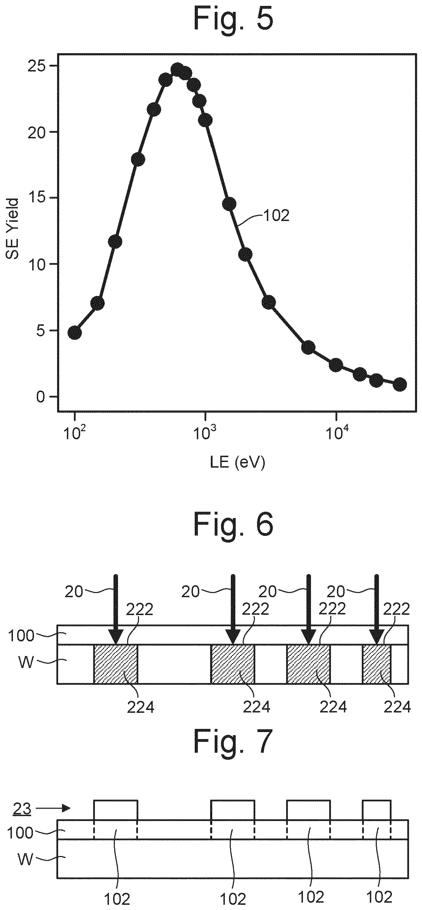

Figure 5 depicts a simulated secondary electron (SE) yield from a diamondoid material irradiated by a primary electron beam over a range of landing energies (LE). The physics of SE generation upon primary electron irradiation is quite similar to that of photon irradiation except that in the latter the photon upon entering the substrate is converted to a photoelectron and then the photoelectron initiates the electron cascading inside the substrate that results in SE generation and emission. The graph demonstrates higher SE yield by a factor of ~25 for the case of a diamondoid substrate. Using a material with high SE yield improves throughput by making more secondary electrons available to contribute to the driven deposition process.

The thickness of the layer 100 of diamondoids is desirably relatively thin, for example less than about 10nm, optionally less than about 8nm, optionally less than about 6nm, optionally less than about 4nm. Arranging for the layer of diamondoids to be relatively thin may by desirable where a portion of the layer is to remain in the device and contribute to device functionality. For example, if the portion of the layer of diamondoids will be used as a gate dielectric it may be desirable to have high capacitance, and capacitance scales inversely with thickness of dielectric.

The layer 100 of diamondoids can be configured to have a band gap selected from a range of selectable band gaps. In the context of diamondoids, the band gap is the energy difference between the highest occupied molecular orbital and the lowest unoccupied molecular orbital. It has been shown that there is typically an inverse relationship between the size of the diamondoids in the layer 100 and the band gap. Selecting diamondoids of larger molecular sizes can thus be used to achieve a smaller band gap in the layer 100. Conversely, selecting diamondoids of smaller molecular sizes can be used to achieve a larger band gap in the layer 100. It has also been shown that the band gap can be tuned by functionalisation over a wavelength range of 180 to 230nm. The layer 100 of diamondoids can be modified with various functional groups, including thiol, hydroxy, and amino groups. The diamondoids can be modified by single or double functionalisation. The band gap may depend sensitively on the size and type of functional group attachment due to the quantum confinement effect.

The layer 100 of diamondoids may be selected and/or functionalized to have a relative dielectric constant below about 3.0, optionally below about 2.8, optionally below about 2.7, optionally below about 2.6, optionally below about 2.5. For example, the relative dielectric constants of lower diamondoids and tetramantane have been found to lie between 2.46 and 2.68. The layer 100 of diamondoids can thus be configured to have a much lower relative dielectric constant than bulk diamond, which is around 5.7. When the layer 100 of diamondoids is retained in an electronic device manufactured using the method of forming the patterned layer of the present disclosure, the layer 100 may be used as a low-*κ* dielectric material. Low-*κ* dielectric materials are understood in the field of semiconductor manufacturing as materials having relative dielectric constants that are small relative to silicon dioxide. Silicon dioxide has a relative dielectric constant of 3.9. Use of low-x dielectric materials contributes to continued scaling down of microelectronic devices by reducing parasitic capacitance, enabling faster switching speeds (e.g., in synchronous circuits) and/or lowering heat dissipation. A range of materials having relative dielectric constants below 3.9 are known but it is often difficult or impossible to integrate such materials into a semiconductor manufacturing process. Providing the layer 100 of diamondoids to improve driving of the deposition process thus has the additional advantage of providing a layer of low-x material that can advantageously be used as part of an electronic device being manufactured, such as to provide electrical isolation between conducting parts of a device (e.g., between wire interconnects or between components of transistors such as between the gate and substrate of a field-effect transistor such as a MOSFET) and thereby or otherwise reduce parasitic capacitance, enable faster switching speeds and/or lower heat dissipation. Although low-*κ* material is desirable for certain device elements, such as for providing isolation between interconnects to reduce parasitic capacitance, other device elements may benefit from higher *κ* (higher relative dielectric constants). For example, it may be desirable for diamondoid material acting as a gate dielectric to have a higher relative dielectric constant. A higher relative dielectric constant for the gate dielectric may enable better electrostatic control of a channel and hence faster switching of the associated transistor. For such applications, the layer 100 of diamondoids may be selected and/or functionalized to have a relative dielectric constant of about 3.0 or higher.

In an embodiment, a method of forming an electronic device is provided. The method comprises forming a patterned layer 23 of material on a substrate W using the method of any of the embodiments described herein. The method of forming the electronic device is configured such that the electronic device comprises a retained portion 102 (see Figures 7, 8 and 10 discussed below) of the deposited layer 100 of diamondoids. The retained portion 102 is configured to contribute to electronic functionality of the electronic device. For example, the retained portion 102 may be configured to perform any known role of a dielectric in semiconductor manufacturing. The retained portion 102 may, for example, be configured to act as a gate dielectric between a gate and a channel formed from two-dimensional material defined by the patterned layer 23 of material.

Figures 6-10 depict example processing sequences during a method of forming an electronic device.

Figure 6 is a schematic side sectional view showing irradiation of a selected portion 22 of a surface of a substrate W during a deposition process. The processing of Figure 6 may correspond to that of Figure 3 and be implemented in any of the ways described herein with reference to Figure 3. In the example shown, the selected portion 22 that is irradiated comprises a plurality of sub-portions 222. Secondary electrons are generated by the irradiation in regions 224 beneath the sub-portions 222. The irradiation drives the deposition process via the secondary electrons generated in the regions 224. The deposited layer 100 of diamondoids promotes secondary electron emission.

Figure 7 is a schematic side sectional view showing a patterned layer 23 of material formed by the deposition process. The patterned layer 23 has a pattern defined by the selected portion 22.

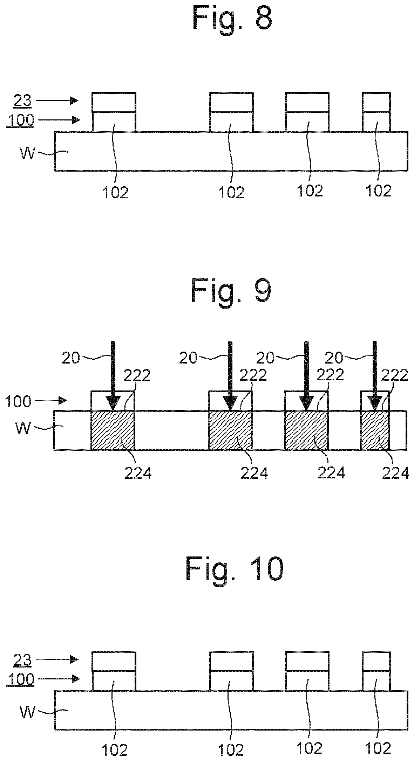

Figure 8 is a schematic side sectional view showing the arrangement of Figure 7 after a portion of the deposited layer 100 of diamonds has been removed by etching. A retained portion 102 of the deposited layer 100 of diamondoids remain behind after the etching and may be incorporated into (e.g., form part of) an electronic device being manufactured. Processing subsequent to the arrangement of Figure 7 may thus be such as to retain the retained portion 102. In some embodiments, the deposited layer 100 may be formed on a dielectric material configured for use in the electronic device as a dielectric in combination with the retained portion 102 of the deposited layer 100. For example, the deposited layer 100 may be formed on a dielectric material configured for use a gate dielectric, such as HfO₂. In such embodiments, ligands can optionally be attached to the surface of the underlying dielectric material (e.g., for use as a gate dielectric, such as HfO₂) in order to functionalise the deposited layer 100 of diamondoids in a desired way when the deposited layer 100 of diamondoids is deposited. In the case of HfO₂, for example, a range of organic ligands can be attached to the HfO₂ surfaces, including for example carboxylic acids, amines and/or thiol groups. Alternatively or additionally, the diamondoids may be functionalised before being deposited on the substrate W. Various deposition processes can be used for depositing the deposited layer 100 of diamondoids, including for example thermal deposition, chemical vapor deposition (CVD) and/or remote plasma CVD.

Figure 9 depicts a variation on the arrangement of Figure 6 in which the deposited layer 100 of diamondoids is initially patterned instead of being initially spatially uniform (unpatterned). A pattern of the deposited layer 100 of diamondoids may thus comprise one or more regions where diamondoids are present in the layer 100 and one or more regions where diamondoids are not present (e.g., which may be referred to as openings in the layer 100). The selected portion 22 that is irradiated may comprise a plurality of sub-portions 222. Secondary electrons are generated by the irradiation in regions 224 beneath the sub-portions 222. The irradiation drives the deposition process via the secondary electrons generated in the regions 224. The deposited layer 100 of diamondoids promotes secondary electron emission. The pattern defined by the selected portion 22 may correspond to (e.g., be substantially the same as) the pattern of the patterned deposited layer 100 of diamondoids. Alternatively, the pattern defined by the selected portion 22 may be different to the pattern of the patterned deposited layer 100 of diamondoids. However, it will typically be desirable for the pattern of the patterned deposited layer 100 of diamonds to contain the pattern defined by the selected portion 22, such that substantially all of the selected portion 22 is coated by a respective portion of the deposited layer 100 of diamondoids. This allows the diamondoids to promote secondary electron emission in all of the selected portion 22, thereby promoting spatially uniform driving of the deposition process throughout the selected portion 22.

Figure 10 is a schematic side sectional view showing a patterned layer 23 of material formed by the deposition process. The patterned layer 23 has a pattern defined by the selected portion 22. In the example shown, the pattern of the patterned layer 23 is substantially the same as the pattern of the patterned deposited layer 100 of diamondoids (comprising retained portions 102).

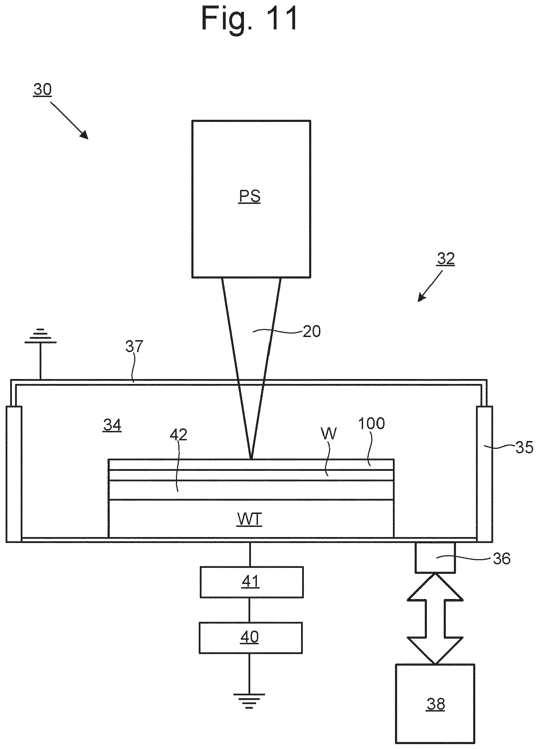

Figure 11 schematically depicts an apparatus 30 for performing the method. The apparatus 30 thus forms a patterned layer 23 of material on a substrate W. The substrate W has a deposited layer 100 of diamondoids on at least a portion of the substrate W. The apparatus 30 comprises a projection system PS. The projection system PS may form part of a lithographic apparatus LA. The projection system PS irradiates the selected portion 22 by projecting a patterned radiation beam from a patterning device MA onto the substrate W. The lithographic apparatus LA may be configured as described above with reference to Figure 1 (e.g., when the irradiation comprises DUV radiation and/or immersion lithography is required) or as described above with reference to Figure 2 (e.g., when the irradiation comprises EUV radiation).

In an embodiment, the lithographic apparatus LA is configured to perform immersion lithography. In such an embodiment, the atomic layer deposition process may comprise a step in which the selected portion 22 is irradiated while the selected portion 22 is in contact with an immersion liquid. Thus, for example, the atomic layer deposition process may comprise a first step comprising adsorption of a precursor from a gaseous precursor material to the substrate W and a second step in which the adsorbed precursor is modified in the selected portion 22 (e.g., to remove a by-product of the adsorption process) by irradiation through the immersion liquid. Any by-product produced by the irradiation through the immersion liquid can conveniently be carried away by flow of the immersion liquid. In an embodiment, the irradiated substrate W is subsequently dried and any further required processing is performed on the dried substrate W.

In an embodiment, an environment control system 32 is provided. The environment control system 32 allows the composition of the environment 34 above the substrate W to be controlled in such a way as to allow the deposition process to proceed. In an embodiment, the environment control system 32 comprises a chamber 35. The chamber 35 is configured to contain the substrate W in a controlled gaseous environment during the irradiation of the substrate W by the patterned beam. The chamber 35 may provide a sealed environment 34 including the selected portion 22 of the surface of the substrate W. The chamber 35 may comprise a pellicle 37 (e.g., a thin membrane) that is substantially transparent to the patterned beam 20 while still acting to limit or prevent movement of particles through the pellicle 37. The pellicle 37 may for example seal the chamber 35 and be substantially transparent to EUV radiation. The patterned radiation beam passes through the pellicle 37 onto the target layer 22 during the irradiation. The chamber 35 should typically be capable of maintaining the controlled gaseous environment at a pressure substantially below atmospheric pressure. The chamber 35 may be configured to provide conditions similar to those provided in an EUV scanner vacuum environment for example.

In some embodiments, all of the substrate W will be within the chamber 35 during the deposition process (e.g., atomic deposition process). In an embodiment, a materials exchange system 36 (e.g., a port into the chamber 35 and associated valves and/or conduits) is provided that allows materials to be added to and removed from the sealed environment 34 to allow different compositional environments to be established within the sealed environment 34. Materials may be provided to and from the materials exchange system 36 by a flow manager 38. The flow manager 38 may comprise any suitable combination of reservoirs, ducting, valves, sinks, pumps, control systems, and/or other components necessary to provide the required flows of materials into and out of the chamber. The different compositional environments achieved in this way may correspond to different respective stages of the deposition process. In some embodiments, the materials added to and removed from the chamber are gaseous, thereby providing compositional environments consisting of different combinations of gases. In an embodiment in which one or more steps of the deposition process are performed by irradiating the substrate W through an immersion liquid, the environment control system 36 may be configured to allow switching between a state in which a controlled liquid environment is maintained above the substrate W (e.g. during exposure in an immersion lithography mode) and a state in which a controlled gaseous environment is maintained above the substrate W (e.g. during adsorption of a precursor from a gaseous precursor material).

In some embodiments, the driving of the deposition process in the selected portion 22 comprises driving a chemical reaction involving a precursor material. The precursor material will be provided as part of the compositional environment established above the substrate W during the irradiation. The driving of the chemical reaction may cause the chemical reaction to proceed at a faster rate than would be the case in the absence of the irradiation. Alternatively, the chemical reaction may be such that it would not occur at all in the absence of the irradiation. In an embodiment, the chemical reaction is endothermic, and the irradiation provides the energy necessary to allow the chemical reaction to proceed. In some embodiments, the chemical reaction is at least partially driven by heat generated in the substrate W by the irradiation. Thus, the chemical reaction being driven by the irradiation may comprise a chemical reaction that requires an elevated temperature to proceed or which proceeds more rapidly at elevated temperatures. In some embodiments, the chemical reaction comprises a photochemical reaction driven by the irradiation. Thus, at least one species involved in the chemical reaction directly absorbs a photon from the irradiation and the absorption of the photon allows the chemical reaction to proceed. In some embodiments, the photochemical reaction comprises a multi-photon photochemical reaction involving absorption of two or more photons by each of at least one species involved in the photochemical reaction. The requirement for two or more photons to be absorbed makes the chemical reaction much more sensitive to variations in the intensity of the irradiation (i.e., the rate of the chemical reaction varies much more strongly as a function of intensity) than would be the case for single photon photochemical reactions. The increased sensitivity to intensity provides improved lateral contrast. In an embodiment, a combination of a photochemical reaction and radiation induced heating is used to provide a well-defined process window in which the chemical reaction is driven locally to produce the pattern. In an embodiment, the chemical reaction is driven by a plasma generated by interaction between the radiation and the substrate W, a layer formed on the substrate W, and/or a gas present above the substrate. The environment above the substrate may be controlled such that the irradiation generates a plasma outside of the substrate W. In an embodiment, the generated plasma is generated in a localized region defined by the irradiation. In an embodiment, the chemical reaction is driven by electrons provided by the irradiation. The electrons may comprise photoelectrons or secondary electrons (electrons generated by inelastic scattering events of a photoelectron or of electrons from an e-beam). In an embodiment, photons absorbed by the substrate W may provide energetic electrons near the surface of the substrate W that participate in the deposition process (e.g., secondary electrons, as described below). In embodiments where a combination of electromagnetic radiation and an e-beam is used, a portion of the deposition process may be driven by electrons from the e-beam.

In some embodiments, flow dynamics of gaseous/liquid co-reactants and/or catalysts and/or precursors are controlled during the deposition process. The control of the flow dynamics can improve the quality of material deposited. The control of flow dynamics may include controlling a direction of the flow (or a vector flow field of the flow). Alternatively or additionally the control of flow dynamics may include controlling a rate of the flow, including for example providing a pulsed flow. In an embodiment, the control of flow dynamics is performed so as to create locally in space and/or time a high density of relevant particles near the deposition location and a low density of the particles near other surfaces (e.g., optics).

In some embodiments, the compositional environment is controlled to provide different mixtures of gases at different times. The different mixtures of gases may be provided to deposit different materials or to switch between a mode where material is deposited and a mode in which material is etched away. The different mixtures of gases may also be used to controllably vary a rate of deposition as a function of time, which may be useful for example to create features with well-defined edges and/or shapes.

In some embodiments, a bias voltage is applied to the substrate W during the irradiation. The bias voltage may be applied using a bias voltage unit 40 as depicted schematically in Figure 11. The bias voltage unit 40 may comprise a voltage source configurable to provide a desired bias voltage waveform. In the arrangement shown, the substrate W is attached to a substrate table WT via an electrostatic chuck 42. The bias voltage unit 40 can apply the bias voltage indirectly by applying a voltage to the substrate table WT and/or electrostatic chuck 42 or can apply the bias voltage directly to the substrate W (e.g., from a side of the substrate W opposite to the selected portion 22 of the surface of the substrate W that is irradiated). The bias voltage may be applied via a matching box or blocking capacitor network 41. As explained below, the bias voltage may increase the extent to which secondary electrons generated by irradiation contribute to driving of a deposition process in the selected portion 22, thereby increasing a rate of the deposition process and improving yield. The bias voltage may achieve this by increasing the proportion of the secondary electrons that reach the surface of the substrate W with suitable energies and/or trajectories.

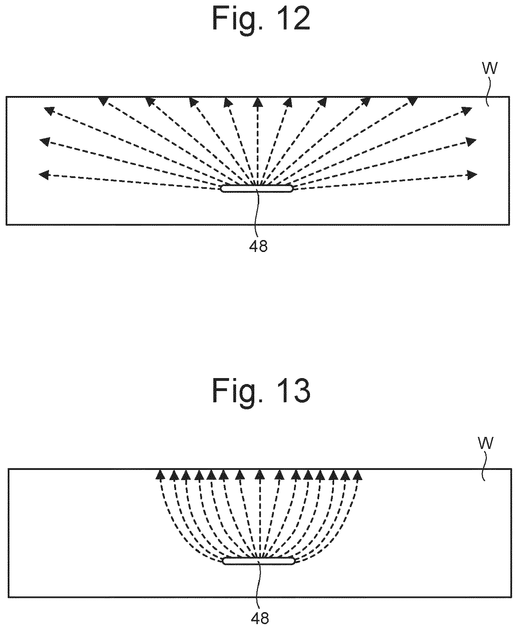

Figures 12 and 13 schematically depict average trajectories (broken line arrows) of secondary electrons from a focus region 48 towards a surface of a substrate W. Figure 12 represents the case where no bias voltage is applied. Figure 13 represents the case where a bias voltage is applied. In each case, the secondary electrons may be generated by photons of the irradiation interacting with the substrate material to generate primary electrons of relatively high energy. The primary electrons then interact further with the substrate material to generate lower energy secondary electrons. A portion of the secondary electrons generated in the substrate W will reach the surface with energies and trajectories suitable for escaping from the surface and contributing to driving of a deposition process at the surface of the substrate W. The secondary electrons may, for example, drive the deposition by causing dissociation of precursor molecules at the surface. The dissociation of the precursor molecules may drive chemical reactions that result in deposition of desired material on the surface.

In the situation represented in Figure 12, where no bias voltage is applied, a portion of the secondary electrons originating from irradiation of the focus region 48 reach the surface of the substrate W but the secondary electrons are relatively spread out. A relatively large proportion of the secondary electrons also arrive at the surface with relatively shallow trajectories (e.g., trajectories that are closer to being parallel to the surface of the substrate than perpendicular to the surface of the substrate). Secondary electrons that reach the surface with energies lower than the work function will be reflected and cannot contribute to inducing deposition of material on the surface. Secondary electrons that reach the surface with energies higher than the work function but at shallow trajectories may also be reflected if the energy associated with the component of propagation perpendicular to the surface is less than the work function.

In the situation represented in Figure 13, where a bias voltage is applied, the bias voltage results in an electric field being established between the focus region 48 and the surface. A maximum magnitude of the electric field will depend on the amplitude of the bias voltage waveform. Electric fields in the range of a few GV/m can be achieved in the substrate W and will be sufficient to modify trajectories of secondary electrons strongly enough to have a useful effect. It has been found, for example, that a thin substrate of SiO₂ deposited by ALD techniques can withstand electric fields of few GV/m without breakdown. The electric field changes trajectories of the secondary electrons such that the secondary electrons impinge on the surface at steeper angles and in a more confined region. This results in a greater proportion of the secondary electrons being able to overcome the work function and contribute to inducing deposition of material on the surface. Additionally, the electric field focuses the secondary electrons into a more spatially constrained region on the surface, thereby increasing an intensity of secondary electrons reaching the surface. A rate of radiation induced deposition per unit area is thus increased by the applied bias voltage. Additionally, the bias voltage promotes improved spatial definition of the radiation induced deposition, thereby improving a quality of the pattern formed on the substrate W by the radiation induced deposition.

In an embodiment, the bias voltage has alternating polarity. The bias voltage thus repeatedly changes sign. The bias voltage may be defined by a periodic (regularly repeating) bias voltage waveform. The bias voltage periodically drives secondary electrons generated inside the substrate by the irradiation towards the surface in the selected portion 22. Using a bias voltage with alternating polarity limits charging of the substrate W during the irradiation. Excessive build up of charge on the substrate W is undesirable because it could lead to deposition being induced over a wider area than desired, for example independently of the pattern defined by the irradiation (e.g., outside of the selected portion 22).

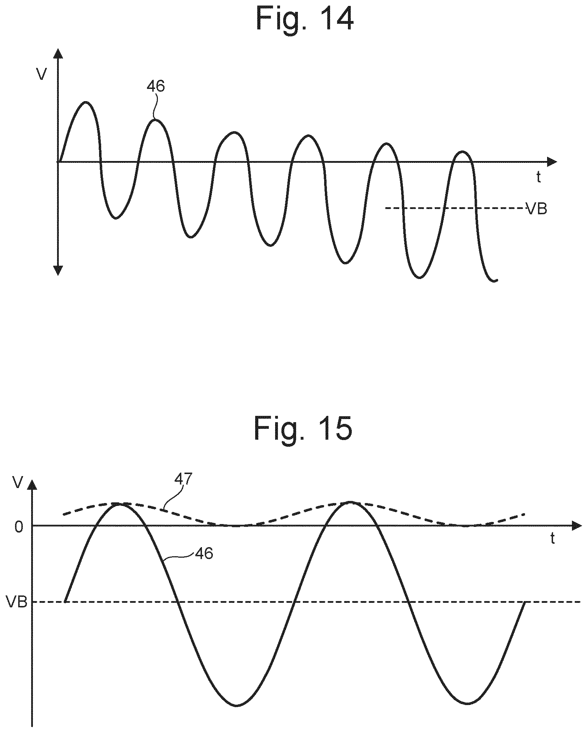

In some embodiments, the bias voltage waveform is sinusoidal. Figures 14 and 15 schematically depict example curves 46 showing variation of voltage at the surface of the substrate W against time during application of the sinusoidal bias voltage waveform. Figure 14 depicts a transient phase immediately after the bias voltage waveform is first applied. Figure 15 depicts a steady state regime that is reached after a short time. As shown Figure 14, the voltage at the surface may drift during the transient phase as the surface becomes negatively charged due to a greater mobility of relatively light negatively charged electrons in a plasma created outside of the substrate by the irradiation in comparison with heavier positively charged ions of the plasma. In the presence of a well-tuned matching box or blocking capacitor network 41, the voltage drifts until the waveform is such that no net charging of the surface occurs when considered over a whole cycle (period) of the applied bias voltage waveform. The DC shift observed in the steady state may be referred to as a DC bias voltage.

The energies of ions impinging on the substrate W from a plasma above the substrate W will depend on how the electric field varies in a sheath volume adjacent to the substrate W during the applied bias voltage. This electric field depends on the difference in voltage between the bulk of the plasma and the voltage at the surface of the substrate W. The voltage in the bulk of the plasma varies relatively little as a function of time in comparison to the voltage in the sheath volume nearer to substrate W. Curve 47 in Figure 15 depicts schematically how the voltage in the bulk of the plasma is expected to vary as a function of time. The voltage in the bulk of the plasma varies with a much smaller amplitude than the voltage in the substrate W.

The bias voltage applied to the substrate W generates an electric field both within the substrate W and in the sheath volume adjacent to the substrate W. The electric field will have the same polarity in both regions and will thus drive movement of electrons in both regions in the same sense. Thus, when electrons in the plasma are driven towards the substrate W the secondary electrons inside the substrate W will be driven away from the surface of the substrate in the selected portion (i.e., downwards in the orientation of Figure 11). When positive ions in the plasma are driven towards the substrate W the secondary electrons in the substrate W will be driven towards the surface of the substrate W in the selected portion 22. Thus, the distribution of energies of secondary electrons driven to the surface in the selected portion 22 by the applied bias voltage will be similar in form to the distribution of energies of ions driven towards the surface by the applied bias voltage.

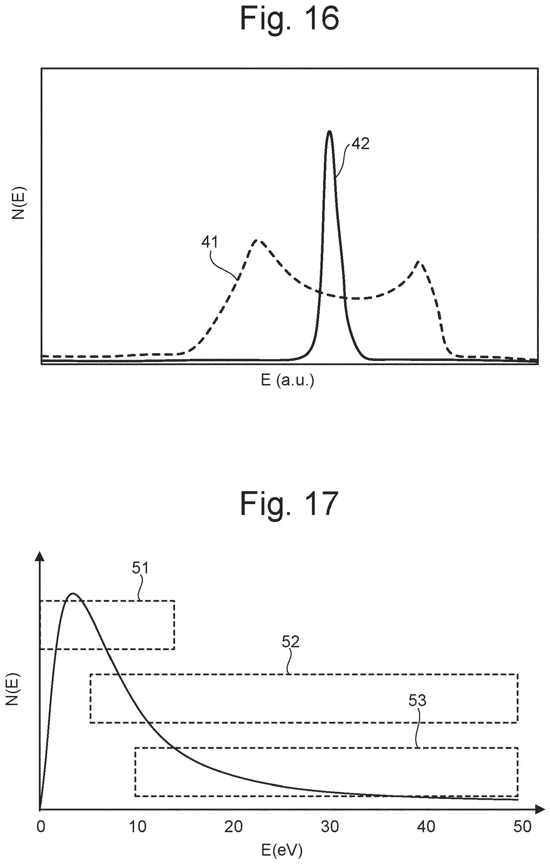

When a sinusoidal bias voltage is applied, the electric field varies as a function of time in a manner that leads to a relatively wide and bimodal spread in the distribution of energies of secondary electrons reaching the surface. This is depicted schematically in curve 41 of Figure 16, which shows a distribution in energies, N(E), as a function of secondary electron energy (E) for the case of a sinusoidal applied bias voltage. Curve 41 is relatively wide (spread over a relatively large range of energies) and is bimodal (has two distinct local minima). The distribution of energies of secondary electrons can be shifted along the energy axis by varying the amplitude of the bias voltage waveform.

In some embodiments, a non-sinusoidal bias voltage waveform is applied. Applying a non-sinusoidal bias voltage provides flexibility to achieve a distribution of energies of the secondary electrons that is more favorable for inducing the desired deposition in the selected portion 22 on the surface of the substrate W. For example, the bias voltage waveform may be tailored such that a large proportion of the secondary electrons reaching the surface of the substrate W in the selected portion 22 have an energy within a range that promotes one or more favored mechanisms of interaction with precursor material. This may be facilitated by selecting the bias voltage waveform to provide a distribution of energies of secondary electrons reaching the surface that has a single maximum (rather than multiple local maxima). Such a distribution of energies may be referred to as a mono-modal distribution.

A favored mechanism of interaction may comprise a favored type of bond dissociation. Figure 17 is a graph showing a typical distribution of secondary electron energies at the surface for a case where no bias voltage is applied. The range of energies is relatively wide with a peak in the range of 3-5eV. Superimposed on the graph are broken line rectangles 51-53 showing approximate ranges of energies for which three different types of bond dissociations are favoured. Rectangle 51 depicts a range of energies that favor dissociative electron detachment (DEA). Rectangle 52 depicts a range of energies that favour neutral dissociation (ND). Rectangle 53 depicts a range of energies that favour dissociative ionization (DI). Applying a sinusoidal bias voltage waveform may provide a range of secondary electrons at higher energies than is the case where no bias voltage is applied. For example, instead of most of the secondary electrons reaching the surface with energies less than 10eV (in the DEA regime), applying the bias voltage may allow most of the secondary electrons that reach the surface to do so with energies above 10eV, optionally above 20eV, optionally above 30eV, optionally above 40eV, optionally in the range of 10eV to 52eV (in the ND and DIregimes), and/or with energies that favor neutral dissociation (ND) and/or dissociative ionization (DI) of precursor material more than dissociative electron detachment (DEA). This may provide an improvement relative to the non-biased case by promoting the ND and DImechanisms relative to the DEA mechanism, which may be favorable for a range of different deposition processes. However, as discussed above with reference to Figure 16, the energy distribution achieved with sinusoidal biasing may still be relatively spread out, such that a significant proportion of the secondary electrons may reach the surface with energies that are too low to favor desired bond dissociation mechanisms (e.g., ND and DI). Tailoring a non-sinusoidal bias voltage waveform to provide a narrower spread in the distribution of energies of the secondary electrons may allow a larger proportion of the secondary electrons to contribute in the most effective way to promoting the deposition process. Using a non-sinusoidal bias voltage waveform may therefore improve throughput.

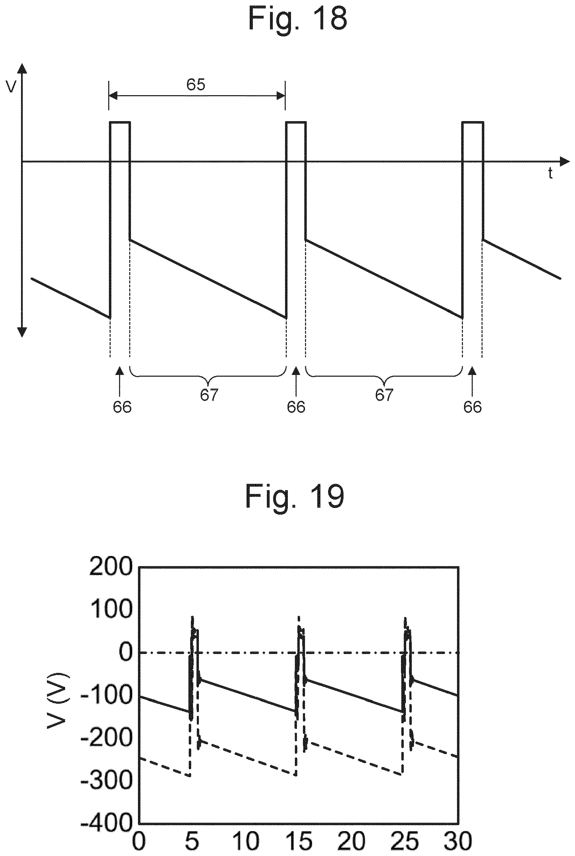

In an embodiment, the non-sinusoidal bias voltage waveform is periodic. An example of such a bias voltage waveform is shown in Figure 18. The curve in Figure 18 represents the variation of the applied voltage in the steady state described above with reference to Figure 15. No significant net charging of the substrate W occurs over a period 65 of the applied voltage waveform in the steady state. Each period 65 of the bias voltage waveform comprises a positive bias portion 66 and a negative bias portion 67. A sum of the durations of the positive bias portion 66 and the negative bias portion 67 may equal the period 65 of the bias voltage waveform.

The voltage applied during the negative bias portion 67 is such that secondary electrons in the substrate W are driven towards the surface of the substrate W in the selected portion 22 (i.e., the upper side of the substrate W in the orientation of Figure 11) during the negative bias portion. Thus, an electrical potential at the surface of the substrate W is higher than an electrical potential within the bulk of the substrate W during the negative bias portion. At the same time, positive ions of the plasma outside the substrate W may be attracted towards the substrate 22.

The voltage applied during the positive bias portion 66 is such that secondary electrons in the substrate W are driven away from the surface of the substrate W in the selected portion 22 during the positive bias portion 66. Thus, an electrical potential at the surface of the substrate W is lower than an electrical potential within the bulk of the substrate W during the positive bias portion. At the same time, electrons of the plasma outside of the substrate W may be attracted towards the target layer 22.

The low masses of the electrons in the plasma means the electrons will respond very quickly to changes in the direction of the electric field and will in essence flow onto the substrate W only during the positive bias portion 66. By contrast, the much heavier ions will flow onto the substrate W not only during the negative bias portion 67 but also during at least a portion of the positive bias portion 66 due to inertial effects. In some embodiments, the duration of the positive bias portion is selected (e.g., is sufficiently short) such that ions continue to flow to the target layer due to inertial effects during all of the positive bias portion.

In some embodiments, as exemplified in Figure 18, the duration of the positive bias portion 66 is shorter than the duration of the negative bias portion 67. The positive bias portion 66 may, for example, be less than one quarter of the period 65 of the bias voltage waveform, preferably less than 1/5 of the period 65, preferably less than 1/6 of the period 65, preferably less than 1/8 of the period 65, preferably less than 1/10 of the period.

In some embodiments, the voltage of the bias voltage waveform is substantially constant during at least a majority of the positive bias portion 66.

In some embodiments, the voltage of the bias voltage waveform varies during at least a majority of the negative bias portion 67 in such a manner as to at least partially compensate for charging of the target layer 22 and/or substrate 24 caused by impingement of the ions during the negative bias portion. Charging may occur for example where the surface and/or a layer below the surface is dielectric. Arranging for the bias voltage to compensate the charging decreases variation of the electric field in the internal volume of the substrate W adjacent to the surface in the selected portion 22, thereby contributing to a reduced spread of energies in the distribution of energies of secondary electrons reaching the surface.

In some embodiments, as exemplified in Figure 18, the variation of the voltage of the bias voltage waveform during the negative bias portion 67 is substantially linear during at least a majority of the negative bias portion 67 (as shown in Figure 18). In some embodiments, the variation of the voltage of the bias voltage waveform during the negative bias portion 67 is such as to maintain a substantially time invariant electric field in an internal volume of the substrate W adjacent to the surface in the selected portion 22 during the negative bias portion 67.

Use of a non-sinusoidal bias voltage waveform facilities provision of a distribution of energies of secondary electrons that has a single maximum (mono-modal), as exemplified by curve 42 in Figure 16, or plural local maxima that are close together in energy. The non-sinusoidal bias voltage waveform thus facilities provision of a distribution of energies of secondary electrons that has a high proportion in a range that favors optimal dissociation mechanisms (e.g., the ND and DI mechanisms discussed above). For example, the bias voltage waveform may be selected such that a single maximum is provided above 10eV, optionally above 20eV, optionally above 30eV, optionally above 40eV, optionally in the range of 10eV to 52eV.

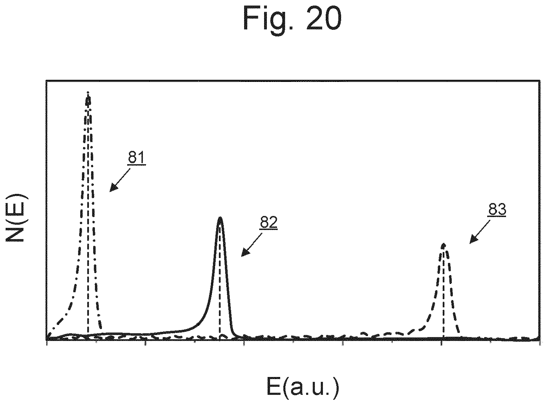

As explained above in the context of sinusoidal bias voltage waveforms, the distribution of energies of ions can be shifted along the energy axis by varying the amplitude of the bias voltage waveform. This is illustrated in Figure 19. In Figure 19, three different bias voltage waveforms are shown with three different amplitudes and the same frequency. Figure 20 shows corresponding distributions of secondary electron energies. Curve 81 (dot-dash line) shows the distribution of energies resulting from applying the lowest amplitude bias voltage waveform in Figure 19. Curve 82 (solid line) shows the distribution of energies resulting from applying the intermediate amplitude bias voltage waveform in Figure 19. Curve 83 (broken line) shows the distribution of energies resulting from applying the highest amplitude bias voltage waveform in Figure 19. The curves 81-83 are example mono-modal curves of the same type as curve 42 shown in Figure 16. The mono-modal form is achieved by using the respective non-sinusoidal waveforms shown in Figure 19. In contrast to the sinusoidal case discussed above with reference to Figures 14-16, as the amplitude is increased it is seen that the spread of energies neither increases significantly in width nor becomes bimodal. The non-sinusoidal bias voltage waveform therefore allows flexible control of the distribution of energies of secondary electrons without the distribution becoming spread out or bimodal. The energies of the secondary electrons can thus be tuned flexibly to be within a small range of an optimal energy for inducing the particular deposition process being used.

In some embodiments, the bias voltage applied by the bias voltage unit 40 comprises a radio frequency waveform. In some embodiments, the frequency of the bias voltage waveform is less than 1 MHz.

Embodiments include the following numbered clauses:
Clause 1. a method of forming a patterned layer of material on a substrate, comprising:
   providing a substrate having a deposited layer of diamondoids on at least a portion of the substrate; and
   irradiating a selected portion of a surface of the substrate during a deposition process, the irradiation being such as to locally drive the deposition process in the selected portion and
   thereby form a patterned layer of material in a pattern defined by the selected portion.
Clause 2. the method of clause 1, wherein the irradiated selected portion is partially or completely covered by the deposited layer of diamondoids.
Clause 3. the method of clause 1 or 2, wherein a thickness of the deposited layer of diamondoids is less than 10nm.
Clause 4. the method of any preceding clause, wherein the diamondoids in the deposited layer are selected and/or functionalized to have a relative dielectric constant higher than about 2.0, optionally equal to or higher than about 3.0.
Clause 5. the method of any preceding clause, wherein the diamondoids in the deposited layer are selected and/or functionalized to have a relative dielectric constant below about 3.0.
Clause 6. the method of any preceding clause, further comprising applying a bias voltage of alternating polarity to the substrate during the deposition.
Clause 7. the method of clause 6, wherein the bias voltage has a non-sinusoidal bias voltage waveform.
Clause 8. the method of clause 7, wherein the bias voltage waveform is periodic.
Clause 9. the method of clause 8, wherein each period comprises:
   a negative bias portion during which secondary electrons in the substrate are driven towards the surface in the selected portion; and
   a positive bias portion during which secondary electrons in the substrate are driven away from
   the surface in the selected portion.
Clause 10. the method of clause 9, wherein the voltage of the bias voltage waveform varies during at least a majority of the negative bias portion in such a manner as to at least partially compensate for charging of the substrate caused by impingement of ions onto the substrate from a plasma during the negative bias portion.
Clause 11. the method of clause 10, wherein the variation of the voltage of the bias voltage waveform during the negative bias portion is substantially linear during at least a majority of the negative bias portion.
Clause 12. the method of clause 10 or 11, wherein the variation of the voltage of the bias voltage waveform during the negative bias portion is such as to maintain a substantially time invariant electric field in an internal volume of the substrate adjacent to the surface in the selected portion during the negative bias portion.
Clause 13. the method of any of clauses 9 to 12, wherein the duration of the positive bias portion is less than 1/4 of the period of the bias voltage waveform.
Clause 14. the method of any of clauses 9 to 13, wherein the voltage of the bias voltage waveform is substantially constant during at least a majority of the positive bias portion.
Clause 15. the method of any of clauses 6 to 14, wherein the bias voltage has a bias voltage waveform selected to provide a distribution of energies of secondary electrons reaching the surface in the selected portion that has a single maximum.
Clause 16. the method of any of clauses 6 to 15, wherein the bias voltage has a bias voltage waveform selected to provide a distribution of energies of secondary electrons reaching the surface in the selected portion in which most of the secondary electrons have energies above 10eV and/or energies that favor neutral dissociation and/or dissociative ionization of precursor material more than dissociative electron detachment.
Clause 17. the method of any preceding clause, wherein the irradiation of the selected portion is performed with electromagnetic radiation having a wavelength less than 100nm.
Clause 18. the method of any preceding clause, comprising controlling an environment above the substrate such that the irradiation generates a plasma outside of the substrate.
Clause 19. the method of any preceding clause, wherein the patterned layer comprises a two-dimensional material.
Clause 20. a method of forming an electronic device, comprising forming a patterned layer of material on a substrate using the method of any preceding clauses, wherein the electronic device comprises a retained portion of the deposited layer of diamondoids, the retained portion configured to contribute to electronic functionality of the electronic device.
Clause 21. the method of clause 20, wherein the retained portion of the deposited layer of diamondoids is configured to function as a gate dielectric and the diamondoids in the deposited layer are optionally selected and/or functionalized to have a relative dielectric constant above about 2.0, optionally equal to or higher than about 3.0.
Clause 22. the method of clause 20, wherein the retained portion of the deposited layer of diamondoids is configured to function as a low-*κ* dielectric, the diamondoids in the deposited layer being optionally selected and/or functionalized to have a relative dielectric constant below 3.0. Clause 23. an apparatus for forming a patterned layer of material on a substrate, comprising:
   a substrate having a deposited layer of diamondoids on at least a portion of the substrate;
   a projection system configured to irradiate a selected portion of a surface of the substrate during a deposition process; and
   an environment control system configured to contain the substrate in a controlled gaseous environment during the irradiation of selected portion, the controlled gaseous environment being such as to support the deposition process.

While the present invention has been described in connection with various embodiments, other embodiments of the invention will be apparent to those skilled in the art from consideration of the specification and practice of the invention disclosed herein. It is intended that the specification and examples be considered as exemplary only, with a true scope and spirit of the invention being indicated by the following claims.

The descriptions above are intended to be illustrative, not limiting. Thus, it will be apparent to one skilled in the art that modifications may be made as described without departing from the scope of the claims set out below.

## Claims

1. A method of forming a patterned layer of material on a substrate, comprising:
providing a substrate having a deposited layer of diamondoids on at least a portion of the substrate; and
irradiating a selected portion of a surface of the substrate during a deposition process, the irradiation being such as to locally drive the deposition process in the selected portion and thereby form a patterned layer of material in a pattern defined by the selected portion.

2. The method of claim 1, wherein the irradiated selected portion is partially or completely covered by the deposited layer of diamondoids.

3. The method of claim 1, wherein a thickness of the deposited layer of diamondoids is less than 10nm.

4. The method of claim 1, wherein the diamondoids in the deposited layer are selected and/or functionalized to have a relative dielectric constant higher than about 2.0.

5. The method of claim 1, further comprising applying a bias voltage of alternating polarity to the substrate during the deposition.

6. The method of claim 5, wherein the bias voltage has a non-sinusoidal bias voltage waveform, and/or wherein the bias voltage waveform is periodic.

7. The method of claim 6, wherein each period comprises:
a negative bias portion during which secondary electrons in the substrate are driven towards the surface in the selected portion; and
a positive bias portion during which secondary electrons in the substrate are driven away from the surface in the selected portion.

8. The method of claim 7, wherein the voltage of the bias voltage waveform varies during at least a majority of the negative bias portion in such a manner as to at least partially compensate for charging of the substrate caused by impingement of ions onto the substrate from a plasma during the negative bias portion.

9. The method of claim 8, wherein the variation of the voltage of the bias voltage waveform during the negative bias portion is substantially linear during at least a majority of the negative bias portion.

10. The method of claim 7, wherein the duration of the positive bias portion is less than 1/4 of the period of the bias voltage waveform, and/or wherein the voltage of the bias voltage waveform is substantially constant during at least a majority of the positive bias portion.

11. The method of claim 5, wherein the bias voltage has a bias voltage waveform selected to provide a distribution of energies of secondary electrons reaching the surface in the selected portion in which most of the secondary electrons have energies above 10eV and/or energies that favor neutral dissociation and/or dissociative ionization of precursor material more than dissociative electron detachment.

12. The method of claim 1, wherein the irradiation of the selected portion is performed with electromagnetic radiation having a wavelength less than 100nm.

13. The method of claim 1, comprising controlling an environment above the substrate such that the irradiation generates a plasma outside of the substrate.

14. The method of claim 1, wherein the patterned layer comprises a two-dimensional material.

15. An apparatus for forming a patterned layer of material on a substrate, comprising:
a substrate having a deposited layer of diamondoids on at least a portion of the substrate;
a projection system configured to irradiate a selected portion of a surface of the substrate during a deposition process; and
an environment control system configured to contain the substrate in a controlled gaseous environment during the irradiation of selected portion, the controlled gaseous environment being such as to support the deposition process.
